# EUROPEAN PATENT APPLICATION

(11) **EP 0 967 617 A1**
(43) Date of publication of application: **29.12.1999**
(21) Application number: 98830377.2
(22) Date of filing: 22.06.1998
(51) Int. Cl.: G11C 11/56

(54) **A floating gate transistor, multi-level cell memory device and method for programming the cells and stabilizing the programmed charge**

(71) Applicant: Texas Instruments Incorporated, Dallas, Texas 75251 (US); Consorzio Eagle, 67051 Avezzano (AQ) (IT)
(72) Inventor: Savaese, Giuseppe, 80122 Napoli (IT); Di Zenzo, Maurizio, 00040 Rocca Priora, Roma (IT); Imondi, Giuliano, 02100 Rieti (IT); Marotta, Giulio, 02043 Contigliano Rieti (IT)
(74) Representative: Taliercio, Antonio

(57) **Abstract**

This invention relates to a method and device for programming and stabilizing a multi-level cell Flash memory device, in which the cells have a number of possible states higher than two, each state corresponding to an allowable threshold voltage range for the transistor of the cell as established by a pair of reference voltages, variable as a function of the cell ageing, said cells being programmed, starting from a full erasure state, by injection of a charge into the floating gate; said method comprises a first programming step for ascertaining the characteristics of the individual cells and one or more subsequent programming steps in which pulses are applied to each cell, the number and the amplitudes of said pulses being individually selectable for each cell, said method further providing that the charge in the individual cells be reset by said stabilization step.

## Description

This invention broadly relates to a floating gate transistor multi-level cell memory device and to a method for programming and stabilizing the programmed charge.

More particularly, this invention relates to a device of the above mentioned kind which makes it possible to program each individual multi-level cell by keeping the particular physical characteristics of it at each instant into account and by maintaining the parallelism of the memory array, both in write and in read operations, and in which it is possible to stabilize the charge stored in the floating or insulated gate of each cell transistor, by compensating the usual variation of it with respect to the programmed value.

It is known that use of both volatile and non-volatile memory devices is extremely popular in electronic applications.

More particularly, memory devices in which each individual cell is formed by a floating gate transistor, known as Flash type devices, are largely utilized as non-volatile electrically programmable memory devices, by adopting a compromise between the programmable and erasable read-only memories (EPROM) that are fast and have a small size, and the electrically programmable and erasable read-only memories that can be handled with electrical signals.

The threshold voltage applied to the gate lead at which the transistor turns on depends on the charge stored in the floating gate. A data item is stored in a Flash memory cell by suitably modifying the charge stored in the floating gate thereof.

A cell can be programmed by utilizing the well known technique in which "hot" electrons are injected into the floating gate by applying particular voltages to the source, drain and gate leads (the source lead being usually connected to ground). The threshold voltage increases as the charge injected into the floating gate increases. A further programming technique provides for initially fully programming the cells, in which the maximum design charge is injected, and for subsequently controllably discharging it, for instance by tunnel effect toward the channel or the source area, as a result of particular voltages coupled to the source, gate and drain leads.

At the end of the programming operation, the cell will be in a state corresponding to a data item and determined by the charge stored in its floating gate and consequently by the threshold voltage of its transistor. Each state of the cell corresponds to a pre-established range of the threshold voltage.

At present, the commercially available devices provide for two possible states of the memory cells, thereby enabling a data storage only under a single bit rate.

The requirement to decrease the active area, also named "chip", of said memory devices has led to exploring novel approaches to enable use of memory cells having more than two possible states, so as to store data under a more than one bit rate.

Such approaches, however, require a high accuracy in injecting the charge into the floating gate in order to locate the cell threshold voltage within restricted allowable ranges.

This entails a number of noticeable problems that the proposed approaches have left without solution, even if they have disclosed complex systems of reference voltages and/or currents and architectures adapted to detect and to store such data.

First of all, the required accuracy in determining and controlling the injected charge is in contrast with the desired programming speed of the memory.

In addition, the Flash cells are subject to ageing, in the sense that the characteristics of a Flash cell change as a function of the time, at a not forecastable rate, due to phenomena connected with the environmental conditions, such as the temperature, the supply voltage and the number of erasing and programming operations performed during the life of the cell. In view of this, the reference system which establishes the allowable ranges for the threshold voltages of the various states should keep the above time unstability into account. In lack of this, when the programmed threshold voltage in a Flash cell is read in different times, different data could be furnished even if the same reading references are utilized.

Furthermore, in a memory chip, the cells have not the same characteristics and, therefore, even if the same voltage reference is maintained for all of the cells, the programming operation should be specifically addressed to each individual cell. In lack of this, should it be desired to store the same data item in two Flash cells having different characteristics, the resulting threshold voltages could be located in different ranges, thereby providing two different readout data items, even if the same programming parameters are utilized.

Lastly, the charge injected into the floating gate basically decreases as a function of the time after programming, due to natural dispersion and the decrease in the stored charge amount can modify the threshold voltage to such an extent as to cause the cell to switch from one programmed state to another one.

It is an object of this invention, therefore, to provide for programming a floating gate transistor multi-level cell memory in accurate, speedy and specific manner for each individual cell, adapted to accommodate the cell ageing and to maintain the parallelism of the memory array both in write and in read operations.

It is a further object to provide for stabilizing the charge stored in the insulated or floating gate of each individual cell, by compensating the natural drift of the programmed value, keeping the specific characteristics, as well as the ageing properties of each cell into account, and maintaining the parallelism and the access times of the memory array both in write and in read operations.

It is specific subject matter of this invention, therefore, a method for programming and stabilizing a floating gate transistor multi-level cell or multi-level Flash cell memory device, having a number of possible states higher than two, each state corresponding to an allowable range for the threshold voltage of the cell transistor, each of said allowable ranges being established by a pair of reference voltages, said cells being programmed starting from a full erasure state by coupling suitable voltages to the source, drain and gate leads and by consequently injecting a charge into the floating gate, said method being characterized by providing a first programming step, in which a first programming pulse is applied to each cell to be programmed, followed by a first read operation aimed at checking the threshold voltage produced by said first pulse in order to sort each cell according to its programming speed, said sorting operation providing for at least two cell categories, said first programming step being followed by one or more subsequent programming steps, programming pulses being applied to each cell and having the same duration in each of said subsequent programming step, the number of said pulses, higher than or equal to zero, and their amplitude being selectable for each cell according to the data item to be stored and/or to the category of the involved cell, each of said pulses being followed by a read operation aimed at checking the threshold voltage, said method being further characterized in that the stabilization step provides for a read operation aimed at checking the threshold voltage of the cells, followed by coupling one or more programming pulses only to those cells the charge of which needs to be reset, said allowable voltage ranges for the threshold voltages of the cell transistors corresponding to each state being variable as a function of the ageing condition of the cells.

It is also specific subject-matter of this invention a multi-level Flash cell memory device characterized in that it is programmed by applying said programming and stabilization method thereto and in that it comprises means for programming the cells, means for determining the reference voltages as a function of the ageing condition of said cells, and means for stabilizing said cells, said reference voltages being specifically designed for said programming, stabilizing and read operations of said cells.

Further characteristics of this invention are set forth in the depending claims.

This invention will be now described by way of illustration and not by way of limitation according to its preferred embodiments, by referring to the annexed drawings in which:
Figure 1 shows a distribution of 4-state Flash cells as a function of the threshold voltage of their floating gate transistors;
Figure 2 is a schematic diagram of a programming circuit for the memory cells according to this invention;
Figure 3 is a block diagram of a first embodiment of the device of this invention;
Figure 4 is a block diagram of a second embodiment of the device according to this invention; and
Figure 5 shows a block diagram of a third embodiment of the device according to this invention.

In the following description, reference will be made to Flash memory device comprising multi-level cells having four possible states, each of which implements a two-bit data item, such cell being programmed, starting from a fully erased condition of the cells, by injecting a charge into the floating gate. It should be understood, however, that the number of the possible state can be of any value higher than two, without so departing from the scope of this invention.

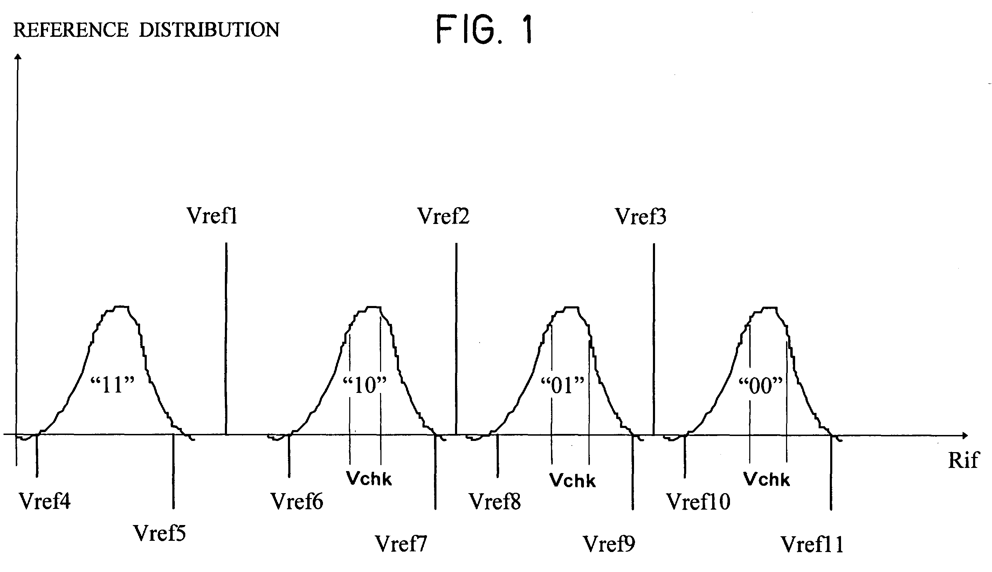

As above said, a conventional write operation in the cells of Flash memory devices is performed by coupling a programming voltage to the gate lead. A programming operation generally includes a number of write steps followed by checking or, in other words, by reading out the data item stored therein, that is to say the threshold voltage established during the write steps. By applying different values of the programming voltages to the gate lead, it is possible to obtain different threshold voltages of the floating gate transistor, each of which corresponds to a different state of the cell. However, since the cells are not provided with identical characteristics, when the same programming voltage is applied during the same time to the gate leads of cells that ought to store the same data item, it will not be possible to obtain the same threshold voltage, but the cells will be distributed according to a statistical, nearly gaussian law, as a function of the threshold voltage. Such a distribution, which has no practical effect in two-state cells, makes most of the multi-level cell devices useless. In this respect, such a distribution for a Flash memory device, the cells of which have four possible states, is shown in Figure 1. The bell-shaped curves of such distributions, corresponding to two states with threshold voltages close to one another, can overlap and cause consequent reading errors of the programmed cells.

Therefore, it is necessary to perform a specific programming operation for each individual multi-level cell of the concerned Flash memory device, after a preliminary classification of its characteristics and by coupling suitable programming voltages to the gate lead, in a sufficient time to position the threshold voltage within the bell corresponding to the data item to be stored.

When sufficiently short pulses are applied, it is possible to dose the charge amount being injected into the floating gate. In this manner, it is possible to control the charge injected into the floating gate based upon the cumulative duration of the programming voltage pulses applied to the gate lead.

When a cell is to be programmed in a specific state, therefore, successive pulse sets are applied thereto, each set being formed by a specific number of pulses for the concerned cell, so as to position the threshold voltage value within narrower and narrower ranges. By such programming method, it is possible to reduce the maximum threshold voltage differences for cells belonging to the same state to a few tens milliVolts.

When pulses of short durations are utilized, even noticeable percentage variations of such duration do not produce correspondent noticeable variations in the programmed threshold voltage.

An even more enhanced control of the charge injected into the floating gate can be obtained by inserting resistances in serial connection to the source and drain leads. By varying the values of such resistances, it is possible to modify the voltage differences applied, during the programming stage, to the transistor lead pairs, thereby modulating the charge amount injected into the floating gate. Other embodiments contemplate one only resistance serially connected to the source or to the drain lead.

Summarizing, a programming operation is carried out by inserting one or more resistances in series to the cell, the values of the resistances being selectable for each cell according to the data item to be stored, and by applying a set of programming pulses, the numbers and the durations of which are selectable for each cell according to its specific characteristics, as extracted by the first check after the first write operation, that is the same for all of the cells.

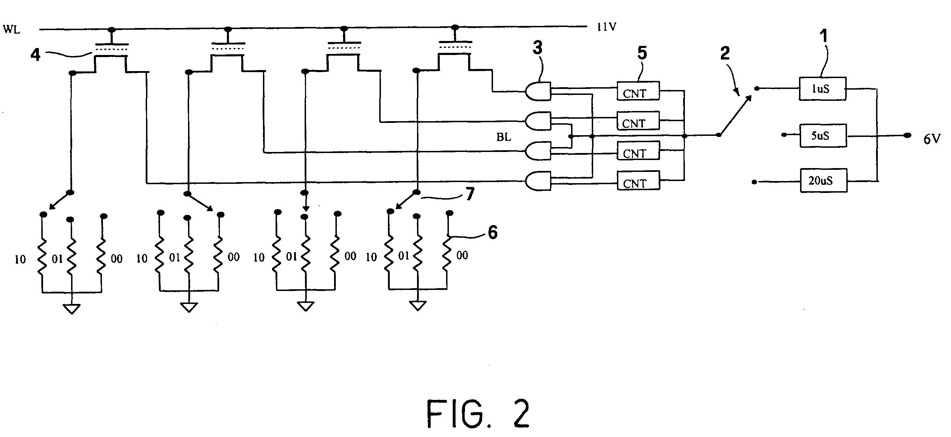

By referring to Figure 2, it can be observed that the construction of the memory is such that the multi-level Flash cells are organized in a matrix structure designated as "array". All the cells belonging to a row are enabled by a row address signal, designated as, "word line" or WL signal, coupled to the gate leads of the transistors comprising the cells. Each row is enabled by a particular signal WL. When the WL signal of a row is high, the drain leads of the corresponding cells are connected to Bit Lines BL. Each Bit Line BL forms a column of the array and it is shared by all of the cells belonging to the corresponding column.

A circuit for programming the memory cells according to this invention comprises a set of pulse generators 1, each adapted to generate pulses of a specific duration and to be connected by means of a switch member 2 to a logic network consisting of a number of AND gates 3 equal to the number of Flash cells 4 having the same row address WL. Each logic AND gate 3 receives both an input signal from a specific pulse generator 1 and the signal from a counter 5 belonging to cell 4, and its output is connected to a bit line BL, that is to say to the drain lead, of the correspondent cell 4. The source leads of cells 4 are connected to ground by means of a selectable resistance 6 in a resistance bank by means of a switch 7.

A memory with physical word size equal to four cells, corresponding to a logic word size equal to 8 bits is shown in Figure 2. It should be understood, however, that the physical word size can be varied, without departing from the scope of this invention.

Each programming step provides for connecting the logic AND gates 3 to the input of a single pulse generator 1, but the pulse is applied a specific number of times for each cell 4, depending on the characteristics of the cell itself because it appears at the output of corresponding gate 3 only if it is enabled by a signal coming from the corresponding suitably initialized counter 5. Furthermore, the impulse amplitude which determines the injected charge amount and consequently the threshold voltage and the stored data, is controlled for each cell 4 according to the selection of the specific source resistance 6 performed through switch 7.

It should be understood that, as a function of the particular architecture of the memory array, the resistance bank can be positioned in different way. For instance, in the cases of an array with source leads all connected to ground, it is possible to shift said resistance banks 6 to the bit lines BL, that is to say to the drain leads of cells 4. In particular, in this case, the introduction of such programming circuit does not entail a noticeable impact upon the global structure of the memory device, since a counter 5, a logic AND gate 3 and a resistance bank 6 will be provided for each bit line BL which, at least in the write stage, are limited to physical typically limited word size of the memory.

It is obvious that, should an architecture be utilized in which the gate leads of the cells belonging to the same row are not shared, it is possible to design a programming circuit that enables to select also the voltage value to be applied to said gate lead.

As it appears in Figure 2, the Flash cells, even if they are subject to an individually specific programming procedure as a function of the data item to be stored as well as of their characteristics, however, are programmed in parallel according to the matrix organization of the memory.

In the preferred embodiment of the programming method according to this invention, a programming algorithm subdivided in four steps is provided.

In the first step, defined as a "spread programming" step, a "long" pulse is applied to all of the cells to be programmed, by inserting resistances of equal values in series to the cells. The check step of the threshold voltage produced by application of such pulse enables the cells to be classified as a function of the programming speed, as checked, namely "weak" cells, namely slow programming cells, "intermediate" and "strong" cells, namely speedy programming cells.

In the second programming step, designated as "jump programming", in the third step, designated as "linear programming" and in the fourth step, designated as "adjustment programming, "long" pulses (having a duration equal to the duration of the spread step pulses), "intermediate" pulse (shorter than the "long" pulses) and "short" pulses (shorter than the "intermediate" pulses) respectively, are applied to the cells to be programmed, by selecting, in each of said steps, the resistance to be serially inserted, based upon the data item to be stored, as well as the pulse number, based upon the data item to be stored and upon the cell classification.

Each pulse injects a charge amount into the floating gate in order to cause a variation of the threshold voltage. Of course, the long pulses of the spread and jump steps modify the threshold voltages of the cell transistors to a larger extent compared to the intermediate pulses of the linear step and to the short pulses of the adjustment step.

It should be understood that it is possible to vary the number of the programming steps and/or the number of pulses of different durations and/or the number of the selectable resistances and/or the values of such resistances as a function of the possible states of the cells, of the desired classification accuracy of the cell characteristics, of the required programming speed, of the threshold voltage programming accuracy as well as of the programming circuit simplicity, without so departing from the scope of this invention.

The goal to be achieved is to bring, by means of a successive approximation procedure, the threshold voltage value within an allowable, very restricted range, centered upon the apex of the distribution bell-shaped curve corresponding to the data item to be stored. After each pulse, a check read operation is performed for the stored data item, thereby stopping the application of subsequent pulses, to prevent them from displacing the threshold voltage outside of said allowable range.

The reference voltage values for the threshold voltages of the Flash cells are shown in Figure 1. In particular, values Vref 1, Vref 2 and Vref 3 are utilized by the device circuitry that performs the read operations and decodes the stored data item, for instance by means of a binary-logarithmic comparation. The value pairs (Vref 4, Vref 5), (Vref 6, Vref 7), (Vref 8, Vref 9) and (Vref 10, Vref 11) are utilized, as representatives of the allowable ranges of the threshold voltages of the cell possible states, by the circuitry of the device that checks the programmed state and controls the various programming steps. In other words, a cell is programmed until the charge injected into its floating gate produces a threshold voltage having a value falling within the allowable range, delimited by one of said pairs corresponding to the data item to be stored. When the upper limits of the allowable ranges as established for the write and stabilization operations are overcome, an indication is obtained that the device is degraded and useless.

As above said, due to ageing of the cells, such values of the reference voltages cannot be absolute values. It is known, for instance, that the threshold voltages of a not-programmed state, indicated in Figure 1 as "11", and of a fully programmed state, indicated in Figure 1 as "00", tend to converge as the ageing of the device increases.

An adjustment of such reference values becomes necessary, therefore, in order to avoid errors both in read operations and in write check operations.

Such an adjustment is achieved by correcting the absolute values according to the threshold voltages of suitable reference cells. In particular, the memory cells are organized in blocks in order to enable a selective erasure of information. Said reference cells are specific for each block and are physically positioned within the block itself. Said reference cells are subject to the same electrical, thermal and mechanical stresses as the memory cells and, in addition, they are erased and re-written any time an erasure operation is enabled on the block they belong to. Therefore, they are representative of the ageing condition of the block memory cells.

In the preferred embodiment, said reference cells are utilized only to store the fully programmed state ("00") and the fully erased state ("11"). It should be understood, however, that also other states can be stored therein, without departing from the scope of this invention.

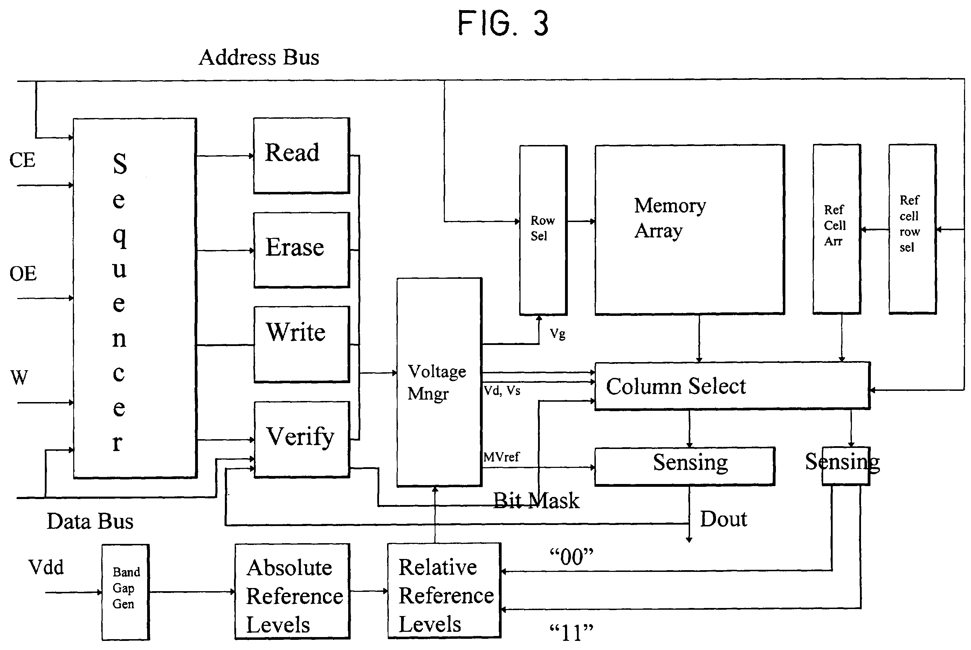

By referring now to Figure 3, it can be observed that a block diagram of a first embodiment of the device according to this invention comprises a "sequencer" block which construes the control signal (CE, OE, W) timing, completing them with the bit pattern existing on the "address bus" and on the "data bus". Said sequencer block also manages the specialized blocks "Read", "Erase", "Write" and "Verify" by which the read, erasure, write and write verification or check operations on the memory cells are performed.

Said specialized blocks also control, through a specific command bus, a "Voltage Mngr" block, which selects suitable voltages for the gate lead shared among the cells of the related row or, when the array architecture makes it possible, for the individual cell gate leads of the row. In addition, for each Flash cell, said Voltage Mngr block selects resistance 6, initializes counter 1 and selects the reference values for the threshold voltages.

Block "Row Select" and "Column Select" are designed to decode the row and the column addresses, respectively, and to bias the gate, drain and source leads of the addressed cells, based upon the gate voltage and upon the resistances selected by the Voltage Mngr block.

The memory array includes cells utilized to store data, as represented by block "Memory Array", and reference cells as represented by block "Ref Cell Arr" and addressed by address decoder block "Ref Cell Row Sel".

The necessary reference voltages for the read, write and programming check operations are generated by block "Band Gap Gent", which furnishes an always constant voltage during the whole life of the device. Based upon such voltage, block "Absolute Reference Levels" generates a first set of absolute voltages. Based upon such set as well as upon the threshold voltages read from suitable reference cells, block "Relative Reference Levels" generates the reference voltages suitably adjusted to accommodate the chip ageing and utilized in all access operations to the Flash cells. Blocks "Band Gap Gen", "Absolute Reference Levels" and "Relative Reference Levels" are substantially simple analog blocks.

Blocks "Sensing" comprise bi-directional amplifiers or Sense Amplifiers adapted to reconstruct in read operations, starting from the voltage or the current furnished by the cell and by the references, the bit pair corresponding to the data item stored in the four state cell and indicates, in write operation, to block "verify", when the charge injected into the cell floating gate has reached a level corresponding to the data item to be stored.

The introduction of the circuitry needed for implementing the above described programming method increases the chip area to a limited extent, but the increase in the memory bit number achieved by utilizing the multi-level cells compensates such area increase, thereby resulting into a net reduction of the chip area for the same number of memory bits. Such reduction increases as the number of cells in the array increases.

As above said, if it is desired to compensate the charge loss in the floating gate, it is necessary to stabilize such charge. The approach suggested according to this invention contemplates adopting a method similar to the Refresh method carried out upon the data stored in dynamic volatile DRAM memories, but it is different in view of the fact that the reset of the data stored in the Flash memory occurs when a noticeable deviation of the threshold voltage from the programmed value is detected.

By reading the data stored in the cells and by checking that the charge accumulated in the floating gate is less than the programmed value, provided that it remains in a range centered thereupon, one or more programming pulses are applied only to those cells whose charge is to be reset, such pulses having a duration such that the operation of the device is not slowed down and/or such that the threshold voltage does not overcome the upper limit of the allowable range associated to the state corresponding to the programmed data item.

By referring again to Figure 1, the programmed value range within which the charge should be maintained can be established according to the specific design requirements, but it should be anyway lower than the distance between two reference values in read operations, for instance Vref 1 and Vref 2 for state "10". It is preferable that said range be not higher, and it would be even better when it is lower than the allowable ranges of the threshold voltages, for instance (Vref 6, Vref 7) for state "10".

In view of the above, an additional reference pair is added, designated Vchk, for each state, so as to evidence the deviation of the charge level from the allowable range and in read operations, a potentially anomalous behaviour can be evidenced, even if the latter is maintained within the limits of a normal operation.

When the charge level is to be reset to optimum conditions, it is sufficient to inject electrons into the floating gate for a time duration in the range of a few tens nanoseconds, even if the total programming time can have a various microseconds duration.

The concerned charge stabilization procedure can be carried out at the device power up stage of the operation, in which the Sequencer scans the whole memory and carries out a complete charge reset in those cells in which the threshold voltage is displaced from the range determined by the Vchk references corresponding to the programmed state. In this case, it is still possible to apply the diagram of Figure 3, in which voltage Mngr selects at power on the reference values Vchk. Such an approach entails an increase in the power up time and the processor connected to the Flash memory device should keep it into account.

Furthermore, said charge stabilization procedure can be carried out also by activation of a particular control function or test-mode of the device, in which the Sequencer scans the whole memory and performs a complete reset of the charge. Such test-mode function can also be enabled by the processor during its inoperative periods, that are extremely frequent in many applications, such as mobile and cellular phones, Personal Computer, transportable video games, telecameras, video cameras and photographic cameras, where Flash EPROM devices are utilized. Such test-mode function can also be manually enabled by the user. The diagram of Figure 3 can be still applied in the test mode.

The charge stabilization procedure can also be carried out during the normal operation of the device, namely during the read operation of a word of the memory. Even if the applied pulses do not completely reset the charge amount accumulated within the floating gate, the read sequences and the consequent successive stabilizations of the same cell can progressively reset the stored charge to the programmed level.

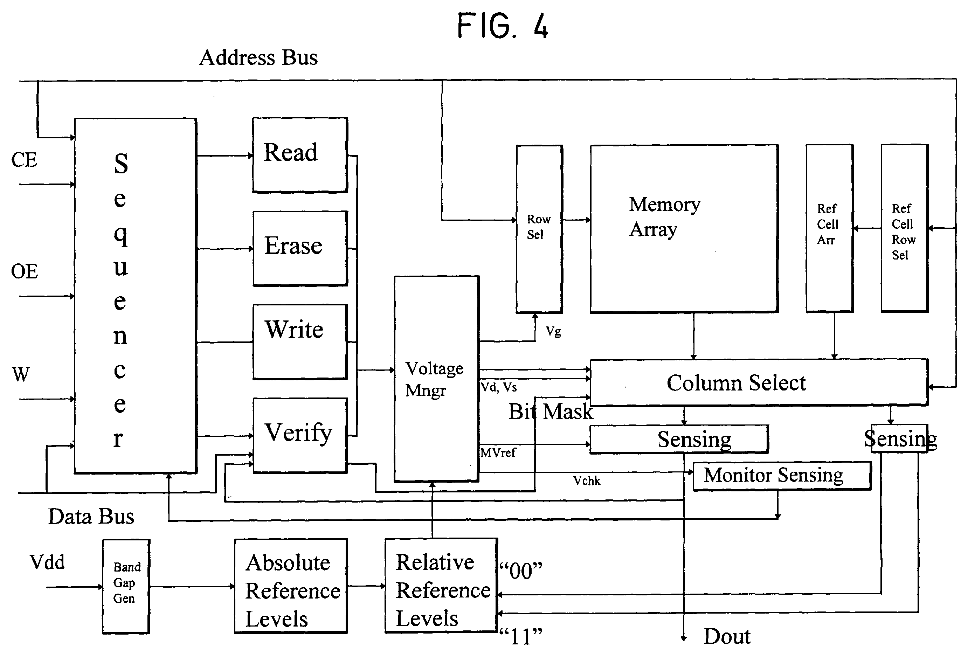

By referring to Figure 4, it can be observed that for this function to be implemented it is sufficient to add to the device an additional Sense Amplifier bank "Monitor Sensing" which will utilize reference voltages Vchk different with respect to the Vref voltages as used during a conventional read operation.

Should a comparison turn out to be negative, an indication furnished to the Sequencer can activate an information reset routine, having a complexity variable as a function of the available time, for instance a single programming pulse or a set of programming pulses interspersed with read operations aimed at checking the reset data item.

The above mentioned three operation modes can be selectively enabled by programmable options at finished product level (write in internal registers of the chip) or at the production stage (metal or bonding options).

In high speed architectures of conventional type, in which typically 8, 16 or 32 bits are read per access, there is only a restricted time tolerance during a read access operation and, therefore, the contemporaneous execution of the charge stabilization can be unpracticable.

Furthermore, the diagram shown in Figure 4 can be applied only to devices in which the number of Sense Amplifiers in reading is limited. Some new architectures, however, are being presently designed, for instance, for use in engines only intended for navigation in Internet and for handling the Electronic Mail and in which substantially null wait times are required for loading into the volatile memory of the host operation system residing on the not-volatile memory. Such new architectures are designed in such a way that the Flash memory interfaces support functions that are similar to the functions of DRAM memories, such as the FPM/EDO and synchronous interfaces and, therefore, they contemplate using thousands Sense Amplifiers in reading. In this case, doubling the number of Sense Amplifier as determined by Monitor Sensing block would be prohibitive.

In this case, it is convenient to use high efficiency error correction techniques, such as the parallel Reed-Solomon technique. Thus, even with extremely speedy devices, it is possible to reset the charge during the standard operation of the memory, since all thousands data picked up during an access operation into the memory remain at the output of the corresponding Sense Amplifier, where they are selected by the processor, for a time duration sufficient for said reset operation to be carried out upon the memory cells which an error detector locates as cells storing error affected data.

Redundancies up to 12% are readily implementable. The additional time needed to calculate the error syndrome is of a small duration, when compared to the time needed in the subsequent charge injection into the failing cell.

The computation of the error syndrome furnishes the information relating to the failing bit locations, so that the original code word can be easily reconstructed.

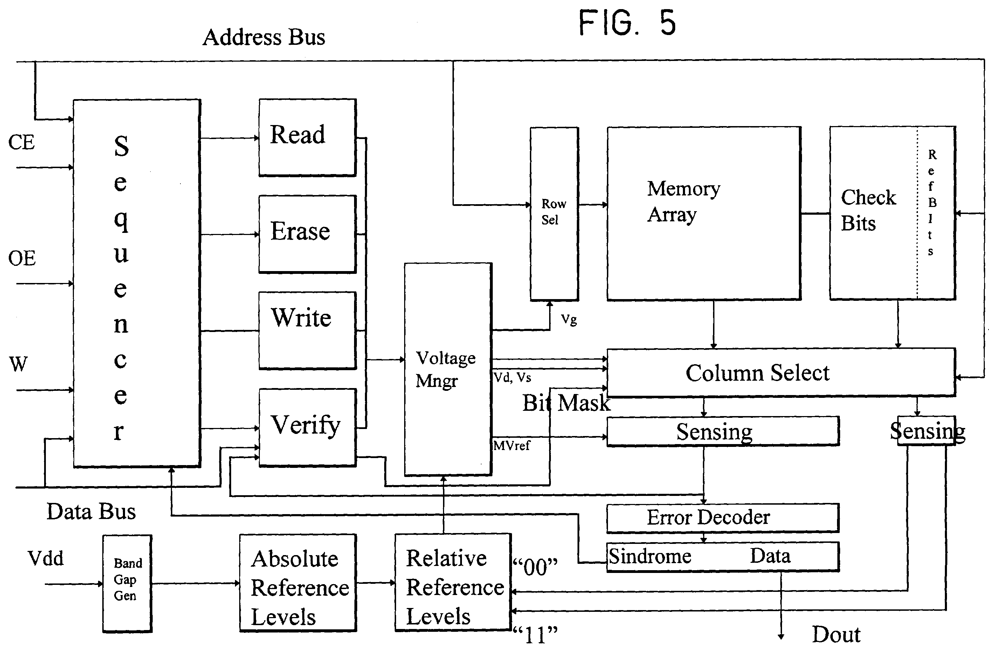

By referring to Figure 5, it can be observed that, when this function is to be implemented, it is sufficient to add an "Error Decoder" block and a "Syndrome Data" block to the device of Figure 3, in order to furnish corrected data and to send a signal to the Sequencer block to start the charge reset routine. Furthermore, a "check Bits" block is to be added in order to introduce the necessary cells as needed by the specifically utilized error correction technique.

It should be noted that the programming parallelism, in which rather complex Sense Amplifiers are provided, is restricted to the sizes of the physical words of the memory, typically 8, 16 or 32, while the reading parallelism can be extended up to many thousands bits.

The scan modes of the whole memory array are applicable also in this case, both on power-up and in test mode, and the various operation modes can be selectively enabled.

The preferred embodiments of this invention have been described and a number of variations have been suggested hereinbefore, but it should expressly be understood that those skilled in the art can make other variations and changes, without so departing from the scope thereof.

## Claims

1. A method for programming and stabilizing a floating gate transistor multi-level cell or multi-level Flash cell memory device, having a number of possible states higher than two, each state corresponding to an allowable range for the threshold voltage of the cell transistor, each of said allowable ranges being established by a pair of reference voltages, said cells being programmed starting from a full erasure state by coupling suitable voltages to the source, drain and gate leads and by consequently injecting a charge into the floating gate, said method being characterized by providing a first programming step, in which a first programming pulse is applied to each cell to be programmed, followed by a first read operation aimed at checking the threshold voltage produced by said first pulse in order to sort each cell according to its programming speed, said sorting operation providing for at least two cell categories, said first programming step being followed by one or more subsequent programming steps, programming pulses being applied to each cell and having the same duration in each of said subsequent programming step, the number of said pulses, higher than or equal to zero, and their amplitude being selectable for each cell according to the data item to be stored and/or to the category of the involved cell, each of said pulses being followed by a read operation aimed at checking the threshold voltage, said method being further characterized in that the stabilization step provides for a read operation aimed at checking the threshold voltage of the cells, followed by coupling one or more programming pulses only to those cells the charge of which needs to be reset, said allowable voltage ranges for the threshold voltages of the cell transistors corresponding to each state being variable as a function of the ageing condition of the cells.

2. A programming and stabilizing method according to claim 1, characterized in that said cell ageing is detected by reading the threshold voltages of suitable reference cells distributed within the memory device, so that each of them is related to an assembly of standard cells of the device, said reference cells being programmed in the various possible states for the cells of the device, each of said reference cells being erased and programmed each time an erasure operation is carried out upon the device cell assembly which it is related to.

3. A programming and stabilizing method according to claim 2, characterized in that said reference cells exclusively store the fully programmed state and the fully erased state.

4. A programming and stabilizing method according to any one of the preceding claims characterized in that the pulse duration at any programming step is not-increasing as a function of the progressive number of the step.

5. A programming and stabilizing method according to any one of the preceding claims characterized in that, at any programming step subsequent to the first one, the application of the pulses is stopped if the further application of a pulse shifts the threshold voltage beyond the upper limit of the allowable range corresponding to the data item to be stored.

6. A programming and stabilizing method according to any one of the preceding claims, characterized in that said one or more pulse applied during the stabilization operation have the same duration, said duration being such that the threshold voltage does not overcome the upper limit of the allowable range for the state corresponding to the programmed data item.

7. A programming and stabilizing method according to any one of claims 1-5, characterized in that said one or more pulses applied during the stabilization operation have a variable duration based upon the charge amount to be reset, said duration being such that the threshold voltage does not overcome the upper limit of the allowable range for the state corresponding to the programmed data item.

8. A programming and stabilizing method according to any one of the preceding claims, characterized in that a control interval is provided for each of said possible states, each of said control intervals being established by a reference voltage pair (Vchk) and being included in the allowable range corresponding to the same state, said reference voltage pair (Vchk) being utilized in said check reading operation carried out by said stabilization operation.

9. A programming and stabilizing method according to any one of claims 1-7, characterized in that said stabilization operation is carried out during the normal operation of the device, by resetting the charge in the cells addressed during a standard read access, which an error correction technique detects as cells in which failing data are stored.

10. A Flash multi-level cell memory device having a number of possible states higher than two, in which the memory cells have a matrix structure or array, designed for application of the programming and stabilizing method according to any one of claims 1-7, characterized in that it comprises means for programming the cells, means for determining the reference voltages as a function of the ageing condition of said cells, and means for stabilizing said cells, said reference voltages being specifically designed for said programming, stabilizing and read operations of said cells.

11. A memory device according to claim 10, characterized in that said programming means for the cells comprise a circuit including a pulse generator assembly (1) selectable and connectable to the Flash cells (4) addressed by said programming operation by means of a logic network, the source lead and/or the drain lead of each of said Flash cells (4) being serially connected to a resistance (6) selectable among a resistance bank, said logic network comprising, for each addressed Flash cell (4), a logic AND gate (3) and a counter (5), said programming means applying a suitable programming voltage to the gate lead of each addressed Flash cell (4).

12. A memory device according to claim 10 or 11, characterized in that the Flash cells (4) belonging to the same row of the memory array have a common gate lead.

13. A memory device according to any one of claims 10-12, characterized in that said means for determining the reference voltages are designed in such a way that the memory cells are organized in blocks, each block including data storage cells and reference cells, said reference cells being programmed in various possible cell states and being erased and programmed each time an erasure operation is enabled in its own block, said reference voltage determining means also comprising a circuitry that, starting from an assembly of absolute or constant reference voltages and from the threshold voltages read from said reference cells, generates the assembly of the reference voltages related to the block including the cells addressed on accessing the array.

14. A memory device according to claim 13, characterized in that said reference cells exclusively store the fully programmed state and the fully erased state of the cells.

15. A memory device according to any one of claims 10-14, characterized in that said cell stabilizing means carry out the stabilizing method according to claim 8 and comprise a circuitry for reading and comparing the data item stored in the cells addressed by the reference voltage pair (Vchk) that establishes said control range, said circuitry enabling the charge reset programming operation when it detects that the cell threshold voltage is not included in said control range.

16. A memory device according to claim 15, characterized in that the stabilization of the addressed cells is carried out during a read access.

17. A memory device according to claim 15, characterized in that said stabilization is carried out at power-up of the device, by means of a scan of the memory and a complete reset of the charge.

18. A memory device according to claim 15, characterized in that said stabilization is carried out on enabling a device control function or test mode, by means of a total scan of the memory and a complete reset of the charge.

19. A memory device according to any one of claims 10-14, characterized in that said cell activation means apply the stabilization method according to claim 9 and comprise a circuitry for reading the data item stored which furnishes a correct output data item and starts the charge reset programming operation when it detects an error condition, the memory array comprising additional Flash cells as needed for the redundancy requested by the error correction technique.
